# EUROPEAN PATENT APPLICATION

(11) **EP 4 700 148 A1**
(43) Date of publication of application: **25.02.2026**
(21) Application number: 25184025.2
(22) Date of filing: 19.06.2025
(51) Int. Cl.: C23C 14/08, C23C 14/30, C23C 14/50, C23C 14/54, F01D 5/28

(54) **METHOD FOR COATING A PART WITH VARIABLE THICKNESS**

(30) Priority: 20.06.2024 US 202463662256 P
(71) Applicant: RTX Corporation, Farmington, CT 06032 (US)
(72) Inventor: HAZEL, Brian T., Avon, 06001 (US); THORNTON, Lane M., Tolland, 06084 (US); CLUM, Carey, Colchester, 06415 (US)
(74) Representative: Dehns

(57) **Abstract**

A method for coating a part (25) includes the steps of mounting a part (25) for rotation relative to a source (26) of coating material; and rotating the part (25) relative to the source (26) of coating material at variable rates of rotation within a single rotation, whereby different portions (12, 14) of the part (25) are coated at a different thickness.

## Description

### FIELD

The present disclosure relates to coating of turbomachinery parts and components.

### BACKGROUND

Turbomachinery such as gas turbine engines and the like have numerous components which are frequently coated with various coatings to provide the part or component with desired properties. For example, thermal barrier coatings (TBC) can expand operation envelope for parts and components to allow more efficient operation of a gas turbine engine. However, in some instances TBC thickness can be a factor in part failure modes.

TBC durability on hot section gas path components (e.g. blades and vanes) is subject to durability concerns from multiple damage modes including thermal spallation on all locations and attack from ingested material deposits composed mainly of calcium-magnesium-aluminum-silicon based materials (CMAS) which is limited to deposit locations (e.g. pressure side of airfoils). Thermal spallation is dominated by the TBC interface temperature (hotter = shorter life) and CMAS attack is dominated by TBC surface temperature (hotter = shorter life). These two criteria restrict optimal coating thermal resistance in current EBPVD (electron beam physical vapor deposition) processing.

EBPVD generally utilizes a constant rotation rate for subjecting parts to the coating source.

Efforts in durability attempt to limit airfoil pressure side (PS) TBC to a select maximum surface temperature to mitigate rapid distress in CMAS. Durability of coating is dependent on the coating toughness and reactivity in CMAS. Yttria stabilized zirconia (YSZ) ceramics such as 7% YSZ are very tough but can be inadequate in preventing CMAS ingress which, if it contacts the metal/ceramic interface, degrades adherence and can lead to spallation. Gadolinium zirconate (GZO), Gd₂Zr₂O₇, ceramic is beneficially reactive with CMAS inhibiting CMAS ingress but can be weaker with respect to crack resistance than YSZ.

### SUMMARY OF THE DISCLOSURE

In one aspect, there is provided a method for coating a part, comprises the steps of: mounting a part for rotation relative to a source of coating material; and rotating the part relative to the source of coating material at variable rates of rotation within a single rotation, whereby different portions of the part are coated at a different thickness.

In a non-limiting configuration, the part is a part of a gas turbine engine.

In another non-limiting configuration, the part is an airfoil of a blade or vane of a gas turbine engine, the blade or vane having a suction side and a pressure side.

In still another non-limiting configuration, the rotating step rotates the pressure side past the source of coating material at a faster rate of rotation than the suction side, whereby coating applied to the suction side is thicker than coating applied to the pressure side.

In a further non-limiting configuration, the coating applied to the suction side is between 1.5 and 5 times as thick as the coating applied to the pressure side.

In a still further non-limiting configuration, a single rotation of the part comprises at least a first and a second rotation segment, and wherein the variable rates of rotation comprise a first rate of rotation when the first rotation segment faces the source of coating material, and a second rate of rotation, different from the first rate of rotation, when the second rotation segment faces the source of coating material.

In another non-limiting configuration, the coating comprises a first layer and a second layer, wherein the rotating step rotates the part relative to the source of coating material at a first variable rate within a single rotation to apply the first layer, and a second variable rate within a single rotation to apply the second layer, whereby the first layer has first different relative thickness around the part, and the second layer has second different relative thickness around the part, different from the first different relative thickness.

In still another non-limiting configuration, the part is an airfoil of a blade or vane of a gas turbine engine, the blade or vane having a suction side and a pressure side, and the rotating step rotates faster when the suction side faces the source of coating material and slower when the pressure side faces the source of coating material for the first layer, and the rotating step rotates slower when the suction side faces the source of coating material and faster when the pressure side faces the source of coating material for the second layer.

In a further non-limiting configuration, the rotating step is carried out so that the first layer is between 1.5 and 5 times thicker at the pressure side than at the suction side, and wherein the second layer is between 1.5 and 5 times thicker at the suction side than at the pressure side.

In a still further non-limiting configuration, the first layer comprises a material having a first thermal conductivity and the second layer comprises a material having a second thermal conductivity that is less than the first conductivity layer.

In another non-limiting configuration, the second thermal conductivity is between 25 and 80% of the first thermal conductivity.

In still another non-limiting configuration, the second thermal conductivity is between 50 and 80 % of the first thermal conductivity.

In a further non-limiting configuration, the first layer comprises yttria stabilized zirconia (YSZ) and the second layer comprises gadolinium zirconate (GZO).

In a still further non-limiting configuration, the source of coating material is a confined source of coating material whereby coating material is deposited on a surface of the part facing the source of coating material.

In another non-limiting configuration, the source of coating material comprises an electron beam physical vapor deposition (EBPVD) source of coating material.

In another aspect, there is provided a blade for a gas turbine engine component comprises the blade having a pressure side and a suction side, and a coating on the blade, wherein the coating is thicker on the suction side than the pressure side.

In a non-limiting configuration, the coating on the suction side is 1.5 to 5 times as thick as the coating on the pressure side.

In another non-limiting configuration, the coating comprises at least a first layer and a second layer, wherein the second layer is further from a surface of the blade than the first layer, wherein the first layer is thicker on the pressure side and the second layer is thicker on the suction side, and wherein the second layer has lower thermal conductivity than the first layer.

In still another non-limiting configuration, the first layer is 1.5 to 5 times as thick as the second layer on the pressure side, and wherein the second layer is 1.5 to 5 times as thick as the first layer on the suction side.

In a further non-limiting configuration, the second layer has a thermal conductivity between 25 and 80% of a thermal conductivity of the first layer.

The foregoing features and elements may be combined in various combinations without exclusivity, unless expressly indicated otherwise. These features and elements, as well as the operation thereof, will become more apparent in light of the following description and the accompanying drawings. It should be appreciated that the following description and drawings are intended to be exemplary in nature and non-limiting.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.
FIG. 1 illustrates an airfoil of a vane or blade;
FIG. 2 illustrates a system for coating parts such as an airfoil for a vane or blade;
FIG. 3 schematically illustrates a system and method for coating a part; and
FIG. 4 schematically illustrates another embodiment.

### DETAILED DESCRIPTION

The detailed description of embodiments herein makes reference to the accompanying drawings, which show embodiments by way of illustration. While these embodiments are described in sufficient detail to enable those skilled in the art to practice the disclosure, it should be understood that other embodiments may be realized and that logical, chemical, and mechanical changes may be made without departing from the scope of the disclosure. Thus, the detailed description herein is presented for purposes of illustration only and not for limitation. For example, any reference to singular includes plural embodiments, and any reference to more than one component or step may include a singular embodiment or step. Also, any reference to attached, fixed, connected or the like may include permanent, removable, temporary, partial, full and/or any other possible attachment option. Further, any steps in a method discussed herein may be performed in any suitable order or combination. Additionally, any reference to without contact (or similar phrases) may also include reduced contact or minimal contact. It should also be understood that unless specifically stated otherwise, references to "a", "an", or "the" may include one or more than one and that reference to an item in the singular may also include the item in the plural. Further, all ranges may include upper and lower values and all ranges and ratio limits disclosed herein may be combined.

This disclosure relates to the coating of parts with coatings such as, for example, thermal barrier coatings (TBCs) and the like. Many components or parts of industrial machinery benefit from coatings to expand their useful operating envelope along with various efficiencies that come with such expanded operating envelopes.

One example is with respect to components and parts of gas turbine engines, for example blades and vanes that find use through the gas turbine engine, for example in compressors, combustors, turbines and the like. In gas turbine engines, there are hot sections and hot gas flow paths to which components and parts of the engine are exposed.

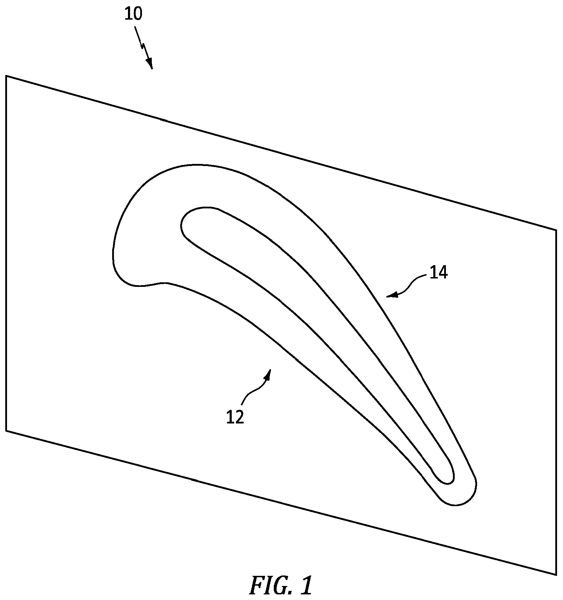

FIG. 1 is a top view of an airfoil 10 showing pressure side (PS) 12 and suction side (SS) 14. While not shown, a thermal barrier coating (TBC) would be present on both sides 12, 14 of airfoil 10.

TBC durability on hot section gas path components (e.g. blades and vanes) is subject to durability concerns from multiple damage modes including thermal spallation on all locations and CMAS attack which is limited to deposit locations (e.g. the pressure side of airfoils) and surface temperatures that exceed the melting point of CMAS. Thermal spallation is dominated by the TBC interface temperature (hotter = shorter life) and CMAS attack is dominated by TBC surface temperature (hotter = shorter life). These two criteria restrict optimal coating thermal resistance in current ceramic coating processes such as but not limited to EBPVD processing.

In the present disclosure, the different concerns on different sides or portions of the part are addressed by depositing ceramic coatings of different thicknesses on different sides to produce desirable conditions in terms of temperature at the surface and interface. This can be done by depositing coatings which then define a suitable range of thermal resistance such that temperatures at the surface and interface can be controlled as desired.

Of course, there are other parts and conditions to which the parts and coatings on the parts can be exposed, and these other parts and conditions could lead to other reasons for the desire to deposit ceramic coatings of different thickness in different locations on such parts. While the present disclosure is made in terms of addressing spallation and CMAS, the present method could be used also to address other conditions and concerns.

TBCs can be applied using numerous techniques and methods. These methods typically include line of sight coating from a source to a surface such as physical vapor deposition (PVD) and thermal spray. EBPVD is one such coating process for ceramic TBC coatings. Others include but are not limited to air plasma spray (APS) and suspension or solution precursor plasma spray (SPS/SPPS). Each of these methods are line of sight (or mostly line of sight) deposition processes where coating is deposited where it is aimed. The concept disclosed herein related to thin pressure side and thick suction side coating can be equally applicable with each of these methods. EBPVD is disclosed further herein as a non-limiting example, but the disclosed method is equally applicable to other line of sight ceramic deposition methods as well.

EBPVD generally utilizes a constant rotation rate of a part relative to the EBPVD source to subject the part to the coating source and produce a relatively constant thickness coating.

As will be further discussed below, the present disclosure is directed to controlling rate of rotation of the part relative to the coating source at different speeds within a single rotation so as to produce different thicknesses of coatings at different locations of the part. It will be appreciated that with each rotation a different amount of ceramic material will be deposited in areas which are rotated past the source point at different rotation speed. This incremental different amount of coating with each rotation will continue until a desired amount of coating has been deposited in all locations. In this regard, it should be noted that the different rotation speeds do not need to be maintained constant through the entire process. For example, deposition of ceramic material could be conducted at variable rotation speed until X thickness is deposited in one zone and 3X is deposited in the other, and then constant rotation coating could be continued to deposit a substantially uniform additional amount of material. The enhanced level of thickness control locally affects coating thickness for individual layers and generally total coating thickness as well.

Control of coating thickness can allow a limiting of the airfoil pressure side TBC temperature to a select maximum surface temperature, which can mitigate rapid distress in CMAS. As set forth above, durability of a coating is dependent on the coating toughness and reactivity in CMAS. YSZ (yttria stabilized zirconia) ceramics are very tough but can be inadequate in preventing CMAS ingress which, if it contacts the metal/ceramic interface, degrades adherence and can lead to spallation. GZO ceramic is beneficially reactive with CMAS, limiting CMAS ingress, but can be weaker with respect to crack resistance than YSZ. Combinations of these ceramics or other alternative ceramics with different balance of properties can be used, and such combinations with varying thicknesses in different locations can be tailored to address specific concerns at different part locations. Thus, in addition to controlling different coating thicknesses at different locations on the part, this approach can be taken with multi-layer coatings as well, also as will be disclosed herein, to produce coatings with multiple layers of different material and different thicknesses of specific layers.

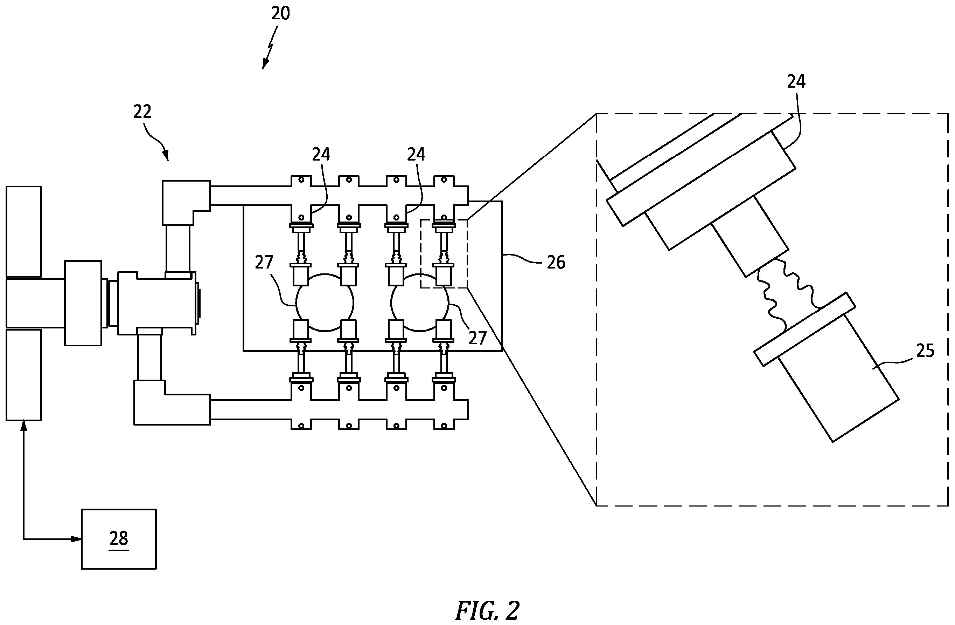

FIG. 2 schematically illustrates a system 20 for coating parts including a structure frequently referred to as a rake 22 having a number of positions 24 which each can support a part or component to be coated. Each position is configured to hold a part 25 and to produce variable rate of rotation of the part relative to the coating source as schematically illustrated in FIG. 2 at 26. In FIG. 2, source is shown schematically as a simple box which represents the hardware used for generating the coating material. Source 26 can actually be a plurality of crucibles, as one non-limiting example, two 2.5" (63.5 mm) diameter crucibles can be positioned along a central axis nearer the outer positions. Source 26 has two circles 27 which represent one non-limiting configuration of a structure of the source.

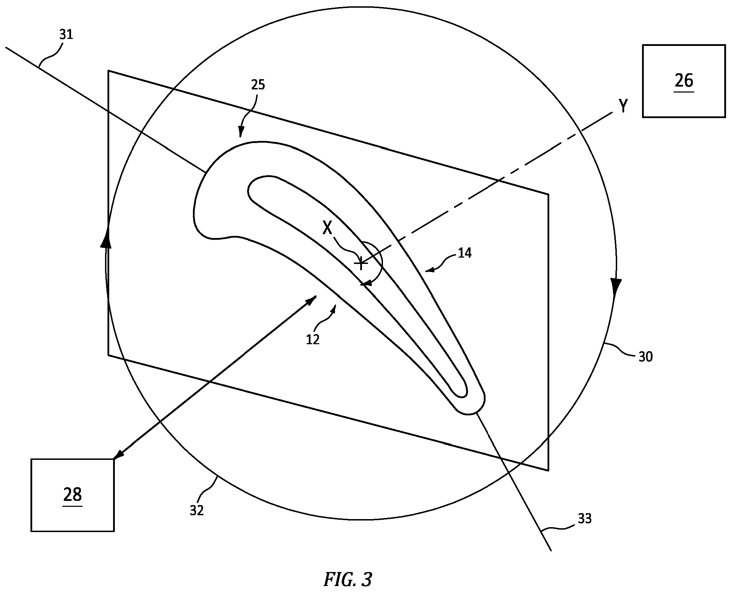

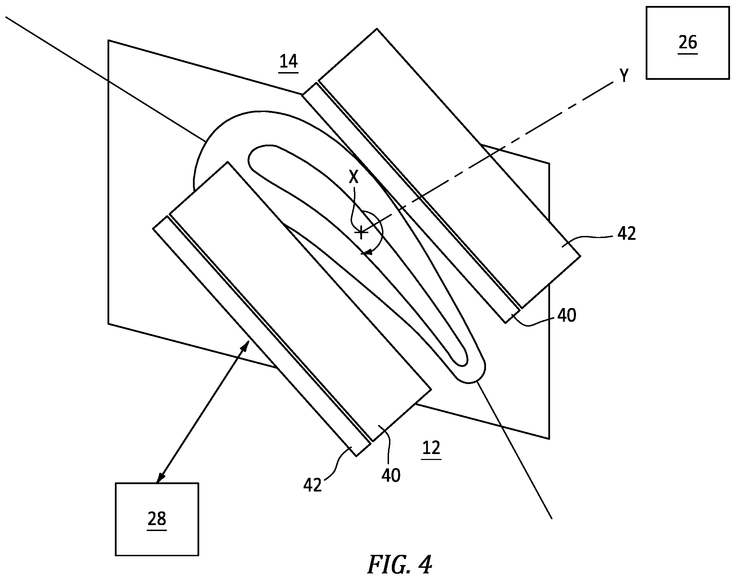

Referring also to FIG. 3, it will be appreciated that part 25 is rotated by a rotating mechanism within each position 24 so as to rotate relative to source 26. FIG. 3 illustrates part 25 having pressure side 12 and suction side 14 as discussed above. A control 28 can be communicated with system 20 and particularly with the motor(s) or other rotation inducing components for each position 24 (as also shown by the broken line arrow in FIG. 4). Control 28 comprises well known storage and processing units configured to execute commands and programming to rotate parts 25 at different rates of rotation.

FIG. 3 illustrates part 25 with two different segments 30, 32 of a single rotation marked. Segment 30 corresponds to a portion of rotation where suction side 14 of part 25 will be facing source 26 of coating material, and segment 32 corresponds to another portion of rotation where pressure side 12 of part 25 will be facing source 26 of coating material. Dividing lines between these segments could be, for example, where marked with lines 31, 33. There are numerous factors that are involved in determining exactly where these line segments are, but these factors would be well known to a person or ordinary skill in the art, and in some instances there will be other dividing lines that separate zones of different rotation speed for different thicknesses of coating.

Control 28 can be configured to rotate part 25 relative to source 26 at one rate or speed for segment 30 and another rate or speed for segment 32. Further, it will be appreciated that although two segments are identified for different speeds of rotation, the full circle of rotation could be divided into 3 or more segments as well, such that 3 or more different zones of different coating thickness can be deposited.

In the non-limiting configuration wherein a thicker coating is desired on suction side 14, rotation through segment or portion 30 will be slower than rotation through segment or portion 32. For one non-limiting example, rotation through segment 32 could be carried out at the equivalent of 15-30 rpm, while rotation through segment 30 could be carried out at the equivalent of 5-15 rpm. Within these ranges, rotation through segment 30 would nevertheless be at a slower rate than rotation through segment 32. Alternatively, the speeds through different segments can be set as a relative difference, that is, rotation speed through segment 32 can be greater than about 1 times the rotation speed through segment 30, and further can be about 2 times rotation speed through segment 30. While suction side 14 is being rotated relatively slowly past source 26, a thicker portion of coating is deposited on this side. Then, when pressure side 12 reaches a rotational position where it begins to face source 26, rotation speed is accelerated to the higher speed so that less coating material will be deposited on pressure side 12. In this way, thickness of the coating applied to part 25 can be controlled to deposit a thicker coating on one side than the other.

A part 25 can be mounted into a corresponding position 24 in this manner and coated with different thicknesses in different portions of the part as described above.

While this portion of the disclosure is made in terms of an EBPVD process, it should be appreciated that other coating processes can be implemented with the same approach to lead to variable thickness coatings. With EBPVD, the source of coating material can be confined to a certain location or zone, and is therefore a confined source of coating material whereby coating material is deposited on a surface of the part facing the source of coating material without substantial deposition on surfaces facing away from the source.

Returning to FIG. 2, each position 24 is or comprises a blade holder mounted to rotate relative to the source of coating material 26. As set forth above, control unit 28 is configured to control the rate of rotation of the blade holder at a variable rate within a single rotation also as discussed above.

It should also be appreciated that the blade holders or positions 24 are spaced from source 26 of coating material along a coating axis Y (FIG. 3), and each blade holder rotates around an axis X, wherein X is substantially perpendicular to Y.

Also as set forth above, the source of rotation could be an electric motor or the like, wherein the blade holder further comprises a motor for rotating the blade holder, and wherein the control unit 28 is programmed to control the motor to rotate the blade holder at the desired variable rate.

In another non-limiting configuration, multi-layer coatings can be applied as indicated above, where each layer can be of a different material and can have different thickness at different locations of the part, and further wherein the overall combined coating can have different or the same combined thicknesses in different locations. This approach can be used to provide final multi-layer coatings that may or may not have the same or different aggregate thicknesses, but which can be tailored to have different thermal resistance at different portions of the part or component. Thermal resistance is defined by the product of thermal conductivity of the material and thickness of the layer of the material. One added value with this approach is an additional benefit from the property differences of the compositions on the selected surfaces.

For example, YSZ has higher toughness and thermal resistance than GZO. So, in the example illustrated in FIG. 4, a lower thermal resistance is produced on the pressure side but there is also a bias of placement of tougher YSZ material on this surface that has more toughness-related damage modes (e.g. CMAS).

In the example illustrated in FIG. 4, two layers 40, 42 of different material are applied with the end result being an aggregate coating (schematically illustrated with block layers 40, 42) of roughly the same thickness, but each layer 40, 42 has a different thickness in a different location, and the layers are made of materials that have different thermal conductivity. The end result is an aggregate coating that can have substantially the same thickness but different thermal conductivity in different locations.

This can be accomplished by operating the EBPVD or other coating source 26 first with one material to apply a first layer and then with a second material to apply a second layer over the first layer. By controlling rotation speed of parts 25 during coating with each different material at a rotation profile, that is, by using different rotation rates within a single rotation, the method can be designed to produce thicker or thinner first and second layers in specific locations.

This type of coating can be referred to herein as duplex or bilayer TBC ceramic coating (two-layer), and can be configured to deposit a thick coating such as GZO coating with a thin YSZ underlayer in locations where CMAS is not depositing (for example at the suction side of the airfoil), and at the same time to maximize thermal protection and toughness to resist CMAS damage in locations where CMAS is depositing but limit GZO second layer thickness sufficient to enable reaction to inhibit CMAS ingress but also to minimize GZO stress following reaction with CMAS. It should be appreciated that the coating could also be made with three (3) or more layers if desired, with the material and thickness of each layer being selected to produce the desired combination of thermal conductivity and toughness.

Enabling different variable rotation rates for first and second ceramic layers can create a first layer such as YSZ to have a fast rotation speed (e.g. 5x) when suction side 14 of airfoil is in view of the evaporation source and a slow rotation speed (e.g. 1X) when pressure side 12 of the airfoil is in view of the evaporation source 26. The yield of such coating will be an approximate 5x difference in YSZ thickness suction side v. pressure side (SS vs PS). Note that the SS thickness of the first layer is minimal to enable maximum interface toughness.

Further, the second layer, which can for non-limiting example be GZO, can be applied to have a slow rotation speed (e.g. 1X) when suction side 14 of the airfoil is in "view", or line of sight, of the evaporation source 26 and a fast rotation speed (e.g. 5X) when pressure side 12 of airfoil is in view of the evaporation source 26. The yield is an approximate 5x difference in GZO thickness.

In one non-limiting example, total thickness of both coatings at the pressure side (PS) is ~2/3 of that at the suction side.

The materials of the different layers of coating can be selected to provide desired properties on both sides of the airfoil. For example, and as described above, a combination of 7wt% YSZ as a first or inner layer and GZO, Gd₂Zr₂O₇ as a second or outer layer can be used to produce a structure such as is illustrated in FIG. 4 wherein inner layer 40 can have a relatively high thermal conductivity (K), and outer layer 42 can have a relatively low thermal conductivity (low K). Further, to provide properties as desired on both pressure side 12 and suction side 14, inner layer 40 can be applied with greater thickness on pressure side 12, while outer layer 42 can be applied with greater thickness on suction side 14. In this way, the combined coating on suction side 14 maximizes thermal resistance to thermal spallation of coating on that surface and reduces component net temperature to manage creep risks. On the other hand, the pressure side 12 coating manages TBC surface temperature by providing a thin CMAS inhibiting layer on top of a tough base.

Thus, following the non-limiting configuration described above and illustrated in FIG. 4, the coating applied comprises a first or inner layer 40 and a second or outer layer 42. The rotating step rotates the part 25 relative to the source of coating material 26 at a first variable rate within a single rotation to apply the first layer 40, and a second variable rate within a single rotation to apply the second layer 42, whereby the first layer has first different relative thickness around the part, and the second layer has second different relative thickness around the part, different from the first different relative thickness.

The material for layer 40 can have a greater thermal conductivity than layer 42, such that the material of layer 40 is referred to as "Full K" while the material of layer 42 is referred to as "low K". Thus, in this non-limiting configuration, layer 40 has twice the thermal conductivity as layer 42. This proportion of thermal conductivity for the different materials is not restrictive and different materials with different relative thermal conductivities can be used. In the example provided in FIG. 4, however, it should be appreciated that the multilayer coating on pressure side 12 will have a greater thermal resistance as compared to the multilayer coating on the suction side 14.

As indicated above, the disclosure is made in terms of an airfoil of a blade or vane of a gas turbine engine, the blade or vane having a suction side and a pressure side. The system and method rotate the part faster when the suction side faces the source of coating material and slower when the pressure side faces the source of coating material for the first layer, and slower when the suction side faces the source of coating material and faster when the pressure side faces the source of coating material for the second layer.

In one non-limiting configuration, the rotating during coating is carried out so that the first layer is about 5 times thicker at the pressure side than at the suction side, and wherein the second layer is about 5 times thicker at the suction side than at the pressure side.

With respect to the thermal conductivities mentioned above, the first material can have a first thermal conductivity, and the second material can have a second thermal conductivity that is less than the first thermal conductivity, wherein the second thermal conductivity can be less than or equal to about 80% of the first thermal conductivity, and greater than or equal to about 25% of the first thermal conductivity. In one non-limiting configuration, the second thermal conductivity is between about 50 and 80% of the first thermal conductivity. With these differences, deposition of different thickness ceramic coatings of the different materials can be configured to produce meaningful overall differences in thermal conductivity in the combined coating thicknesses on both sides of the part as desired.

Also as indicated above, in one non-limiting configuration, the inner or first layer comprises YSZ and the outer or second layer comprises GZO or Gd₂Zr₂O₇.

The foregoing description is exemplary of the subject matter of the subject matter disclosed herein. Various non-limiting embodiments are disclosed, however, one of ordinary skill in the art would recognize that various modifications and variations in light of the above teachings will fall within the scope of the appended claims. It is therefore to be appreciated that within the scope of the appended claims, the disclosure may be practiced other than as specifically described. Thus, the scope of the present claims is not specifically limited by the details of specific embodiment disclosed herein, but rather the claims define the full and reasonable scope of the disclosure.

## Claims

1. A method for coating a part (10; 25), comprising the steps of:
mounting a part (10; 25) for rotation relative to a source (26) of coating material; and
rotating the part (10; 25) relative to the source (26) of coating material at variable rates of rotation within a single rotation, whereby different portions of the part (10; 25) are coated at a different thickness.

2. The method of claim 1, wherein the part (10; 25) is a part (10; 25) of a gas turbine engine.

3. The method of claim 1, wherein the part (10; 25) is an airfoil (10; 25) of a blade or vane of a gas turbine engine, the blade or vane having a suction side (14) and a pressure side (12).

4. The method of claim 3, wherein the rotating step rotates the pressure side (12) past the source (26) of coating material at a faster rate of rotation than the suction side (14), whereby coating applied to the suction side (14) is thicker than coating applied to the pressure side (12), optionally wherein the coating applied to the suction side (14) is between 1.5 and 5 times as thick as the coating applied to the pressure side (12).

5. The method of any preceding claim, wherein a single rotation of the part (10; 25) comprises at least a first and a second rotation segment (30, 32), and wherein the variable rates of rotation comprise a first rate of rotation when the first rotation segment (30) faces the source (26) of coating material, and a second rate of rotation, different from the first rate of rotation, when the second rotation segment (32) faces the source of coating material.

6. The method of claim 1, wherein the coating comprises a first layer (40) and a second layer (42), wherein the rotating step rotates the part (10; 25) relative to the source (26) of coating material at a first variable rate within a single rotation to apply the first layer (40), and a second variable rate within a single rotation to apply the second layer (42), whereby the first layer (40) has first different relative thickness around the part (10; 25), and the second layer (42) has second different relative thickness around the part (10; 25), different from the first different relative thickness.

7. The method of claim 6, wherein the part (10; 25) is an airfoil (10; 25) of a blade or vane of a gas turbine engine, the blade or vane having a suction side (14) and a pressure side (12), and wherein the rotating step rotates faster when the suction side (14) faces the source (26) of coating material and slower when the pressure side (12) faces the source (26) of coating material for the first layer (40), and wherein the rotating step rotates slower when the suction side (14) faces the source (26) of coating material and faster when the pressure side (12) faces the source (26) of coating material for the second layer (42), optionally wherein the rotating step is carried out so that the first layer (40) is between 1.5 and 5 times thicker at the pressure side (12) than at the suction side (14), and wherein the second layer (42) is between 1.5 and 5 times thicker at the suction side (14) than at the pressure side (12).

8. The method of claim 6 or 7, wherein the first layer (40) comprises a material having a first thermal conductivity and the second layer (42) comprises a material having a second thermal conductivity that is less than the first conductivity layer.

9. The method of claim 8, wherein the second thermal conductivity is between 25 and 80% of the first thermal conductivity, optionally between 50 and 80 % of the first thermal conductivity.

10. The method of any of claims 6 to 9, wherein the first layer (40) comprises yttria stabilized zirconia (YSZ) and the second layer (42) comprises gadolinium zirconate (GZO).

11. The method of any preceding claim, wherein the source (26) of coating material is a confined source (26) of coating material whereby coating material is deposited on a surface (12, 14) of the part (10; 25) facing the source (26) of coating material, optionally wherein the source (26) of coating material comprises an electron beam physical vapor deposition (EBPVD) source (26) of coating material.

12. A blade for a gas turbine engine component, the blade having a pressure side (12) and a suction side (14), and a coating on the blade, where the coating is thicker on the suction side (14) than the pressure side (12).

13. The blade of claim 12, wherein the coating on the suction side (14) is 1.5 to 5 times as thick as the coating on the pressure side (12).

14. The blade of claim 12 or 13, wherein the coating comprises at least a first layer (40) and a second layer (42), wherein the second layer (42) is further from a surface (12, 14) of the blade than the first layer (40), wherein the first layer (40) is thicker on the pressure side (12) and the second layer (42) is thicker on the suction side (14), and wherein the second layer (42) has lower thermal conductivity than the first layer (40), optionally wherein the second layer (42) has a thermal conductivity between 25 and 80% of a thermal conductivity of the first layer (40).

15. The blade of claim 14, wherein the first layer (40) is 1.5 to 5 times as thick as the second layer (42) on the pressure side (12), and wherein the second layer (42) is 1.5 to 5 times as thick as the first layer on the suction side (14).
